# EUROPÄISCHE PATENTSCHRIFT

(11) **EP 2 396 857 B1**
(45) Veröffentlichungstag und Bekanntmachung des Hinweises auf die Patenterteilung: **20.02.2013**
(21) Anmeldenummer: 09797029.7
(22) Anmeldetag: 17.12.2009
(51) Int. Cl.: H01R 11/28

(54) **VORRICHTUNG ZUR BEFESTIGUNG EINES BOLZENS IN EINER POLKLEMME**
DEVICE FOR SECURING A POST IN A TERMINAL CLAMP
DISPOSITIF POUR FIXER UN BOULON DANS UNE BORNE POLAIRE

(30) Priorität: 13.02.2009 DE 102009000828
(43) Veröffentlichungstag der Anmeldung: 21.12.2011
(73) Patentinhaber: Robert Bosch GmbH, 70442 Stuttgart (DE)
(72) Erfinder: MAZINGUE-DESAILLY, Stephan, 71640 Ludwigsburg (DE); HELLWIG, Roland, 71679 Asperg (DE); MUELLER, Michael, 71277 Rutesheim (DE)
(86) Internationale Anmeldenummer: PCT/EP2009/067415
(87) Internationale Veröffentlichungsnummer: WO 2010/091762

(56) Entgegenhaltungen:
- DE-A1-102004 037 874
- DE-B3-102004 046 855

## Beschreibung

### Stand der Technik

Die Erfindung geht aus von einer Vorrichtung zur Befestigung eines Bolzens in einer Polklemme nach der Gattung des unabhängigen Anspruchs. Eine gattungsgemäße Vorrichtung ist aus der DE 10 2004 046 855 B3 bekannt. Zur Befestigung eines Messwiderstands an der Polklemme und zur Befestigung eines Endes einer Massµeleitung am Messwiderstand ist ein Bolzen mit einer Isolierhülse bekannt, wobei der Bolzen mit dem Messwiderstand durch eine Press- oder Nietverbindung verbunden ist.

Es ist Aufgabe der vorliegenden Erfindung, die Verbindung zwischen Bolzen und Polklemme zu vereinfachen bei Erreichung einer hohen mechanischen Festigkeit. Diese Aufgabe wird gelöst durch die Merkmale des unabhängigen Anspruchs.

### Vorteile der Erfindung

Die erfindungsgemäße Vorrichtung mit den Merkmalen des unabhängigen Anspruchs hat demgegenüber den Vorteil, dass sich die mechanische Festigkeit erhöht, ohne auf eine Niet- bzw. Pressverbindung angewiesen zu sein. Dies wird dadurch erreicht, dass Mittel zur Verdrehsicherung des Bolzens vorgesehen sind. Diese Mittel nehmen insbesondere Kräfte, die eine Rotation des Bolzens hervorrufen würden, auf. Dadurch können Zugkräfte am Batteriekabel über die Polklemme abgeleitet werden. Die vorgeschlagene Lösung kann weiterhin als vormontierte Polklemme mit Bolzen ausgeführt werden. Auf einfache Art und Weise wird über den Bolzen eine mechanische Anbindung an die Polklemme bei gleichzeitiger elektrischer Isolation erreicht.

In einer zweckmäßigen Weiterbildung ist vorgesehen, dass als Mittel zur Verdrehsicherung eine Aufnahme in der Polklemme vorgesehen ist, welche mit einer Aufnahmekontur zusammenwirkt. Diese Aufnahmekontur ist vorzugsweise sternförmig oder rechteckförmig ausgebildet, sodass entsprechende Kräfte gleichmäßig aufgenommen werden können.

In einer zweckmäßigen Weiterbildung ist vorgesehen, dass der Isolierkörper aus einem flexiblen Material, vorzugsweise Kunststoff oder Silikon, besteht. Dadurch wird ein einfaches Zusammenfügen von Bolzen mit Isolierkörper, Polklemme und gegebenenfalls Messelement unter eventuell notwendigem Toleranzausgleich ermöglicht

In einer zweckmäßigen Weiterbildung ist vorgesehen, dass der Isolierkörper als Spritzgießteil ausgebildet ist. Dieser kann direkt auf die Polklemme und den Bolzen aufgespritzt werden, sodass diese Teile zu einer Einheit umspritzt werden können. Dadurch kann ein Fügeprozess entfallen. Weiterhin erhöht sich die Positioniergenauigkeit des Bolzens in der Polklemme.

In einer zweckmäßigen Weiterbildung besteht der Isolierkörper aus einer Beschichtung des Bolzens, vorzugsweise aus einem isolierenden Lack oder einem anderen, die Oberfläche des Bolzens elektrisch isolierenden Material. Der Bolzen wird anschließend in der Polklemme montiert, beispielsweise gepresst.

In einer zweckmäßigen Weiterbildung ist vorgesehen, dass der Bolzen mit einem vorzugsweise umlaufenden Kragen versehen ist zur zumindest teilweisen Aufnahme des Messelements. Somit dient der Bolzen gleichzeitig als mechanische Auflagefläche für das Messelement und erhöht damit die mechanische Festigkeit der Anordnung. Hierbei ist der Außendurchmesser des Kragens zweckmäßiger Weise geringer als der Außendurchmesser des Isolierkörpers. Damit wird eine zuverlässige elektrische Isolation zwischen Polklemme und Bolzen erreicht. Weitere zweckmäßige Weiterbildungen ergeben sich aus weiteren abhängigen Ansprüchen und aus der Beschreibung.

### Zeichnung

Mehrere Ausführungsbeispiele der Vorrichtung zur Befestigung eines Bolzens in einer Polklemme sind in der Zeichnung dargestellt und werden nachfolgend näher beschrieben.

Es zeigen:
die Figur 1 eine schematische Darstellung der gesamten Baugruppe mit einem in einer Polklemme angeordneten isolierten Bolzen,
die Figur 2 ein zweites Ausführungsbeispiel mit durch Umspritzung gebildetem Isolierkörper,
die Figur 3 ein weiteres Ausführungsbeispiel mit einem beschichteten Bolzen,
die Figur 4 eine Detailansicht der Polklemme zur Aufnahme des Bolzens,
die Figur 5 den zu Figur 4 zugehörigen Bolzen,
die Figur 6 eine perspektivische Ansicht, teilweise geschnitten, der Verbindung zwischen Polklemme und Bolzen,
die Figur 7 eine perspektivische Ansicht einer Batteriemessklemme mit in der Polklemme integriertem Bolzen,
die Figur 8 eine perspektivische Darstellung gemäß Figur 7, teilweise in Schnittansicht sowie
die Figur 9 einen prinzipiellen dreiteiligen Aufbau der Batteriemessklemme.

Eine schematisch dargestellte Polklemme 10 weist eine Aufnahme 20 auf, in der ein im unteren Bereich von einem Isolierkörper 18 umgebener Bolzen 14 elektrisch isoliert von der Polklemme 10 angeordnet ist. Mit diesem Bolzen 14 ist elektrisch leitend ein Messelement 16 kontaktiert. Zwischen der Unterseite des Messelements 16 kann im Bereich der Aufnahme 20 eine Isolierung 19 angeordnet sein, um besonders an dieser Stelle sicherzustellen, dass kein elektrisch leitender Kontakt zwischen Messelement 16 und Polklemme 10 erfolgt. Diese Isolierung 19 könnte auch Bestandteil des Isolierkörpers 18 sein. Über den Bolzen 14 wird ein Batteriekabel 12 elektrisch und mechanisch mit der Polklemme 10 verbunden.

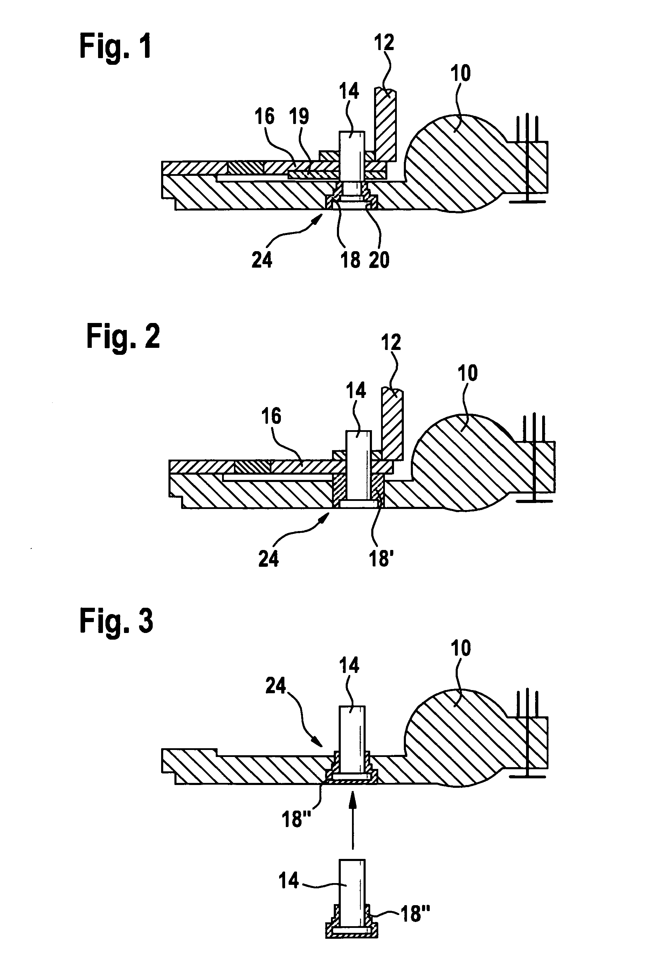

Das Ausführungsbeispiel nach Figur 2 unterscheidet sich von demjenigen der Figur 1 lediglich in einer anderen Ausführung des Isolierkörpers 18. Dieser ist als Spritzgießteil dergestalt ausgeformt, dass sowohl Polklemme 10 wie auch Bolzen 14 zu einer Einheit umspritzt sind. Dabei liegt die Unterseite des Messelements 16 auf der Oberseite des Isolierkörpers 18 auf.

Der Bolzen 14 dient der Befestigung des Batteriekabels 12. Hierzu ist beispielsweise ein nicht eigens dargestelltes Gewinde vorgesehen. Um den Bolzen 14 wird der Kabelschuh des Batteriekabels 12 gelegt und anschließend mit einer Mutter befestigt. Um diesen Bolzen 14 ist auch das vorzugsweise flächig ausgebildete Messelement 16 gelegt. Der Bolzen 14 wiederum ist durch eine geeignete Verbindung 24 über den Isolierkörper 18 mechanisch mit der Polklemme 10 verbunden. Bei dem Ausführungsbeispiel gemäß Figur 1 ist der Isolierkörper 18 beispielsweise als hülsenförmiger Körper ausgeprägt. Der Isolierkörper 18 muss hierzu eine ausreichende Flexibilität besitzen, um das Zusammenfügen von Bolzen 14 und Polklemme 10 zu ermöglichen. Die Flexibilität des Isolierkörpers 18 dient auch dem Toleranzausgleich. Eventuell kann über Verrastungen sichergestellt werden, dass der Bolzen 14 sicher in der Polklemme 10 positioniert ist. Das Material des Isolierkörpers 18 ist vorzugsweise ein Kunststoff oder ein Elastomer (beispielsweise Silikon). Bei dem Ausführungsbeispiel gemäß Figur 2 ist der Isolierkörper 18 als Spritzgießteil ausgeführt. Hierzu werden Bolzen 14 und Polklemme 10 - beabstandet voneinander positioniert - durch einen isolierenden Kunststoff umspritzt, sodass der Isolierkörper 18 entsteht. Vorzugsweise ragt die Oberkante des Isolierkörpers 18 etwas über die Oberseite der Polklemme 10 hinaus, sodass sichergestellt ist, dass das Messelement 16 von der Polklemme 10 an der Stelle des Bolzens 14 elektrisch isoliert angeordnet ist.

Bei dem Ausführungsbeispiel gemäß Figur 3 ist der Bolzen 14 in seinem unteren Bereich mit einer Beschichtung 18" versehen. Der Bolzen 14 wird im zu isolierenden Bereich mit einem Lack oder einer anderen geeigneten, isolierten Oberfläche versehen. Dieser so beschichtete Bolzen 14 wird anschließend in die Polklemme 10 montiert, beispielsweise gepresst.

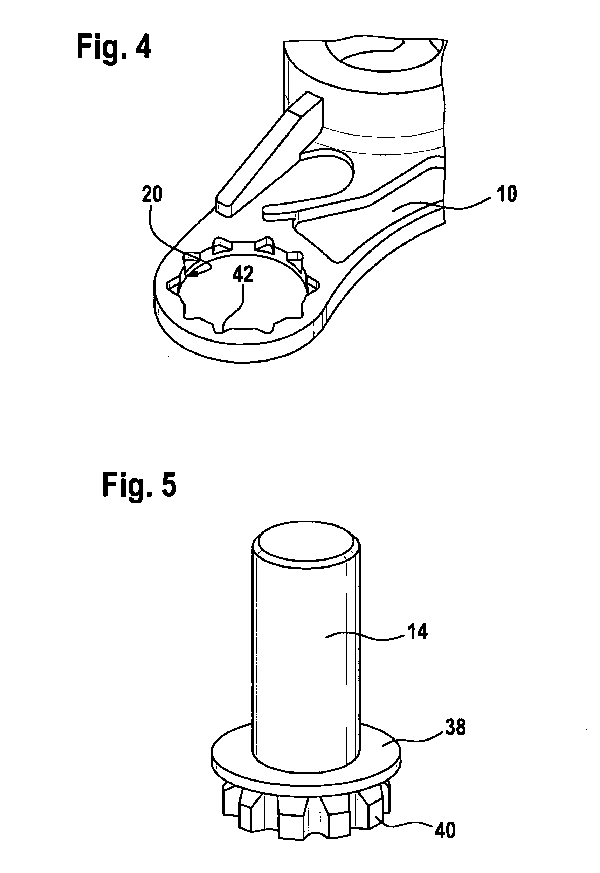

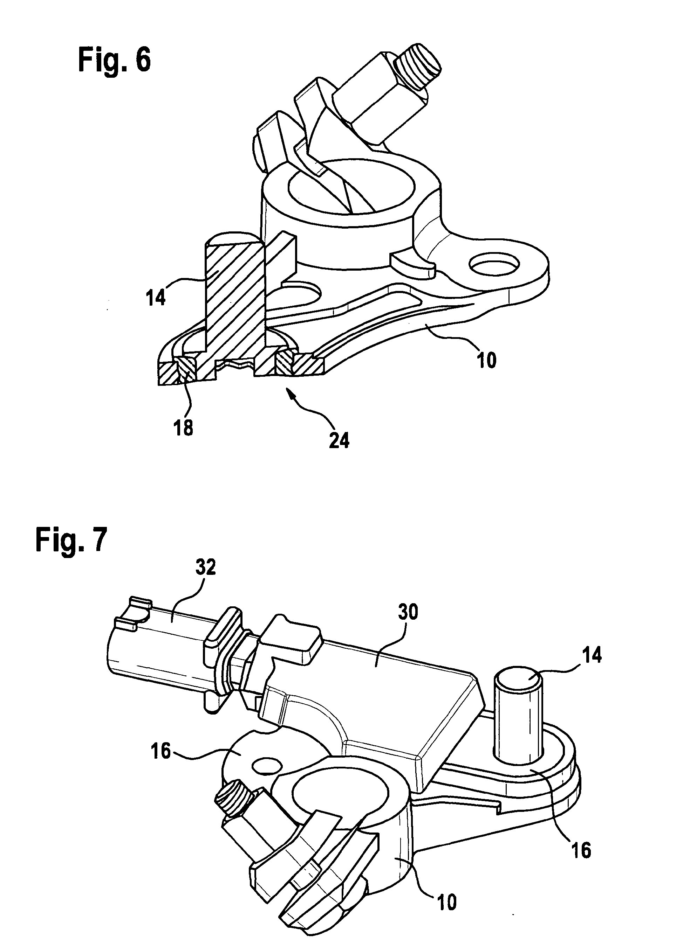

In Figur 4 ist die Aufnahme 20 der Polklemme 10 detaillierter gezeigt. So lässt sich eine im Wesentlichen sternförmige Aufnahmekontur 42 ausmachen, welche so ausgeführt ist, dass eine Verdrehung des Bolzens 14 einerseits sowie eine Bewegung des Bolzens 14 nach unten in axialer Richtung sicher vermieden wird. Der zugehörige Bolzen 14 ist in Figur 5 gezeigt. In entsprechender Weise weist auch er eine Befestigungskontur 40 auf, die sternförmig gebildet ist. Oberhalb der Befestigungskontur 40 ist ein radial umlaufender Kragen 38 vorgesehen. Der Außendurchmesser des Kragens 38 ist vorzugsweise größer als derjenige der Befestigungskontur 40. Die in den Figuren 4 und 5 gezeigten Komponenten sind in Figur 6 im montierten Zustand gezeigt. Der Isolierkörper 18 ist so ausgebildet, dass eine elektrische Isolation zwischen Polklemme 10 und Bolzen 14 erreicht wird. Weiterhin ist der Außenradius der Oberseite des Isolierkörpers 18 größer als der Außenradius des Kragens 38. Damit wird auf zuverlässige Art und Weise eine Isolation zwischen Polklemme 10 und Bolzen 14 erreicht

Die Aufnahmekontur 42 kann zur Unterbindung einer Verdrehung beispielsweise rechteckförmig, prismatisch, dreieckförmig oder grob rechteckförmig mit ein oder zwei abgerundeten Seitenflächen ausgeführt sein. Zweckmäßiger Weise könnte die Aufnahmekontur 42 in einer Ebene senkrecht zur Achsrichtung des Bolzens 14 Gegenflächen aufweisen, so dass der Bolzen 14 in definierter axialer Lage montiert werden bzw. die Aufnahmekontur 42 auch in axialer Richtung wirkende Kräfte aufnehmen kann.

Im Ausführungsbeispiel gemäß Figur 7 ist die Polklemme 10 gezeigt, die mit einem nicht dargestellten Batteriepol einer Batterie, beispielsweise einer Kraftfahrzeugbatterie, verbunden werden kann. Dazu können die nicht näher bezeichneten Schenkel der Polklemme 10 so aufeinander zu bewegt werden, dass sie den Batteriepol umschließen. Die Anordnung umfasst ferner das Messelement 16. Das Messelement 16 ist auf der einen Seite durch eine Verpressung 34 mittels Durchsetzfügens unmittelbar mit der Polklemme 10 mechanisch und elektrisch verbunden. An der Stelle der Verpressung 34 weist die Polklemme 10 eine Öffnung mit rückseitiger Anfasung auf. In diese Öffnung wurde der Anschluss des Messelements 16 mittels Durchsetzfügens so verpresst, dass sich im Bereich der Anfasung ein Hinterschnitt des Messelements 16 ausbildet. So kommt es quasi zu einer Vernietung der Polklemme 10 mit dem Messelement 16.

Auf der rechten Seite ist die Aufnahme 20 der Polklemme 10 gezeigt, die der Befestigung des Bolzens 14 dient. Der Bolzen 14 ist hierzu beispielsweise zylinderförmig ausgeführt und ragt senkrecht zur planaren Ebene des Messelements 16 nach oben. Zwischen Bolzen 14 und Polklemme 10 ist radial den Bolzen 14 umgebend der Isolierkörper 18 angeordnet. Durch die gezeigte Anordnung wird sichergestellt, dass der Batteriestrom zwischen dem Bolzen 14 zum Anschluss des Batteriekabels 12 und der mit dem Batteriepol verbundenen Klemme tatsächlich über das Messelement 16 fließt und nicht kurzgeschlossen wird. Eine entsprechende Aussparung des Messelements 16 ist auf den Außendurchmesser des Bolzens 14 abgestimmt. Das Messelement 16 liegt teilweise auf dem sich radial vergrößernden Kragen 38 auf dem Bolzen 14, teilweise auch auf der Oberseite des als Hülse ausgebildeten Isolierkörpers 18 auf. Die nach oben ragende Seite des Bolzens 14 kann mit einem nicht dargestellten Gewinde versehen sein, um einen Kabelschuh eines Batteriekabels 12, vorzugsweise das Massekabel, mittels Schraubverbindungen zu befestigen. Das Messelement 16 wird im Bereich des Bolzens 14 lediglich seitlich von einem Gehäuse 30 umgeben, während die Oberfläche des Messelements 16 freiliegend ist.

Das Messelement 16 wird in Richtung des Gehäuses 30 in dessen Inneres geführt. Dort befindet sich das eigentliche Messelement, beispielsweise ein elektrischer Widerstand aus einem bestimmten Material wie beispielsweise Manganin. Innerhalb des Gehäuses 30 ist auch eine nicht dargestellte Elektronik angeordnet, die den Spannungsabfall am Messwiderstand 16 erfasst und weiter auswertet. Weiterhin können anhand weiterer Daten wie beispielsweise Batteriespannung, Temperatur oder ähnliches Batteriezustandsgrößen wie der Ladezustand (State of Charge: SOC) oder Alterung (State of Health: SOH) der Batterie ermittelt werden. Diese Daten können über eine nicht dargestellte Datenleitung, die über einen Stecker 32 angeschlossen wird, an weitere Steuergeräte wie beispielsweise ein Energiemanagement-Steuergerät weitergegeben werden. Über diesen Stecker 32 könnte auch die weitere Versorgungsspannung zugeführt werden.

Das Messelement 16 wird an der von dem Bolzen 14 abgewandten Seite aus dem Gehäuse 30 herausgeführt. Dort erfolgt auch die elektrische Kontaktierung mit der Polklemme 10 in einer vorzugsweise mittels Durchsetzfügens erhaltenen Verpressung 34. Wesentlich ist, dass jedoch die elektrische Kontaktierung zwischen Messelement 16 und Polklemme 10 erst - bezogen auf den eigentlichen Messwiderstand - auf der von dem Bolzen 14 abgewandten Seite erfolgt. So wird der Strom vom Batteriepol über die Polklemme 10, die Verbindung im linken Anschlusspunkt des Messelements 16, den im Inneren des Gehäuses 30 liegenden Messwiderstand hin zum Bolzen 14 geführt, an dem dann das Batteriekabel 12 anzuschließen ist.

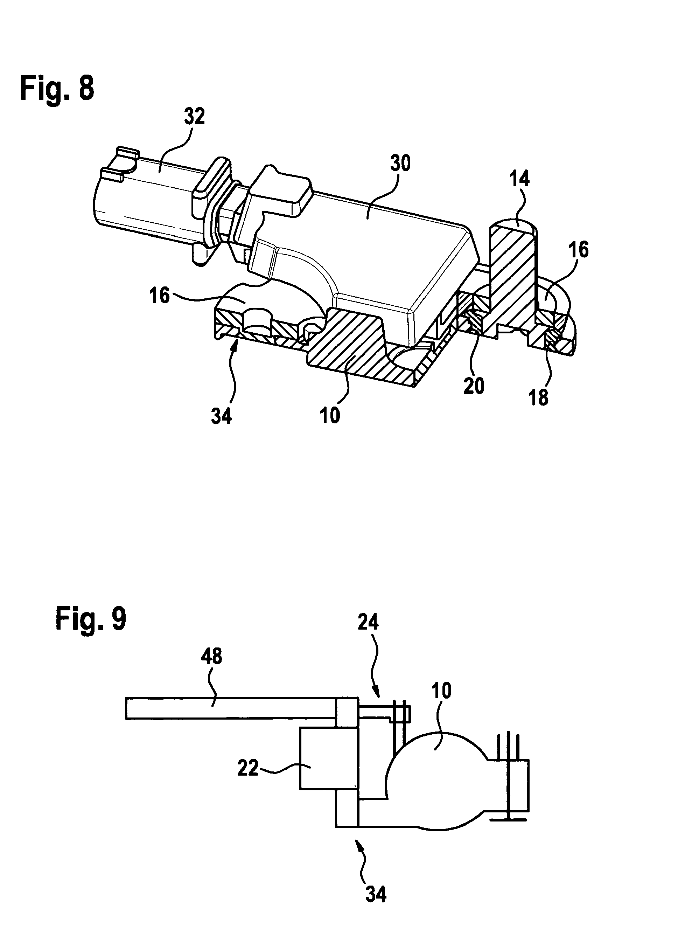

In Figur 9 ist ein dreiteiliges Batteriesensorkonzept gezeigt. Dieses ist vorzugsweise aufgebaut aus Polklemme 10, Elektronikeinheit 22 sowie Kabelanschluss 48. Beispielhaft sind Polklemme 10 und Elektronikeinheit 22 durch die Verbindung 24 und die Verpressung 34, wie bereits ausgeführt, miteinander befestigt. Die Aufbau- und Verbindungstechnik wird dadurch optimiert, indem der Batteriesensor in drei Teile partitioniert wird, nämlich Polklemme 10, Elektronikeinheit 22 und Kabelanschluss 48. Die Verbindung dieser drei Partitionen erfolgt im Fertigungsablauf erst am Ende. Damit soll die Flexibilität insofern erhöht werden, als eine Anpassung an verschiedenste Einbauräume lediglich durch den Austausch der Polklemme 10 und/oder des Kabelanschlusses 48 möglich ist. Änderungen an der Elektronikeinheit 22 sind nicht notwendig. Alle drei Einheiten 10, 22, 48 können getrennt voneinander gefertigt und erst am Ende des Fertigungsprozesses miteinander verbunden werden.

Der komplette Aufbau ist in der Polnische handelsüblicher Kraftfahrzeugbatterien integrierbar, bzw. ragt etwas darüber hinaus. Die Verbindungstechnik zwischen den drei Einheiten 10, 22, 48 kann so gewählt werden, dass diese sich wieder lösen lassen. Damit ergibt sich die Möglichkeit, einzelne Einheiten zu entfernen bzw. anzubringen, ohne den gesamten Sensor von der Batterie zu demontieren bzw. darauf zu montieren. Ein großer Vorteil liegt darin, dass ein Entfernen des Kabelanschlusses 48 ohne Polklemmen-Demontage möglich wird.

Die Vorrichtung zur Befestigung eines Bolzens in einer Polklemme eignet sich insbesondere für den Einsatz eines in der Polklemme integrierten Batteriesensors, ist jedoch hierauf nicht eingeschränkt.

## Patentansprüche

1. Vorrichtung umssend :
- zumindest eine Polklemme (10) zum Anschluss an einen Batteriepol,
- zumindest eine Elektronikeinheit (22) oder ein Messelement (16), verbunden mit der Polklemme (10),
- zumindest einen Bolzen (14) zum Anschluss eines Batteriekabels (12), wobei der Bolzen (14) über eine Verbindung (24) mit der Polklemme (10) mechanisch befestigt ist,
- zumindest einen Isolierkörper (18), der Bolzen (14) und Polklemme (10) elektrisch voneinander isoliert, **dadurch gekennzeichnet, dass** Mittel (18, 38, 40, 42) zur Verdrehsicherung des Bolzens (14) gegenüber der Polklemme (10) vorgesehen sind.

2. Vorrichtung nach Anspruch 1, **dadurch gekennzeichnet, dass** als Mittel zur Verdrehsicherung in der Polklemme (10) eine Aufnahme (20) mit einer Aufnahmekontur (41) vorgesehen ist, die Kräfte in radialer und/oder axialer Richtung bezogen auf die Längsachse des Bolzens (14) aufnimmt.

3. Vorrichtung nach Ansprüch 2, **dadurch gekennzeichnet, dass** als Mittel zur Verdrehsicherung eine Befestigungskontur (40) am Bolzen (14) vorgesehen ist, die mit der Aufnahmekontur (42) zusammenwirkt.

4. Vorrichtung nach Ansprüch 3, **dadurch gekennzeichnet, dass** die Befestigungskontur (40) sternförmig ausgebildet ist.

5. Vorrichtung nach einem der Ansprüche 3 oder 4, **dadurch gekennzeichnet, dass** der Isolierkörper (18) zumindest zwischen Aufnahmekontur (42) und Befestigungskontur (40) angeordnet ist.

6. Vorrichtung nach einem der vorhergehenden Ansprüche, **dadurch gekennzeichnet, dass** der Isolierkörper (18) aus einem flexiblen Material, vorzugsweise Kunststoff oder einem Elastomer, besteht.

7. Vorrichtung nach einem der vorhergehenden Ansprüche **dadurch gekennzeichnet, dass** der Isolierkörper (18) durch eine Umspritzung gebildet ist.

8. Vorrichtung nach einem der vorhergehenden Ansprüche 1-6, **dadurch gekennzeichnet, dass** der Isolierkörper (18) durch eine Beschichtung (18") des Bolzens (14) gebildet ist.

9. Vorrichtung nach einem der vorhergehenden Ansprüche, **dadurch gekennzeichnet, dass** der Bolzen (14) einen zumindest teilweise umlaufenden Kragen (38) aufweist

10. Vorrichtung nach Ansprüch 9, **dadurch gekennzeichnet, dass** der Außendurchmesser des Kragens (38) geringer ist als der Außendurchmesser des Isolierkörpers (18).

11. Vorrichtung nach einem der vorhergehenden Ansprüche 9 oder 10, **dadurch gekennzeichnet, dass** der Kragen (38) zur Aufnahme des Messelements (16) dient.

12. Vorrichtung nach einem der vorhergehenden Ansprüche, **dadurch gekennzeichnet, dass** die Polklemme (10) und das Messelement (16) mittels einer Verpressung (34) mechanisch und elektrisch leitend miteinander verbunden sind.

## Claims

1. Device comprising:
- at least one terminal clamp (10) for connection to a battery terminal,
- at least one electronics unit (22) or a measuring element (16), connected to the terminal clamp (10),
- at least one post (14) for the connection of a battery lead (12), the post (14) being mechanically secured to the terminal clamp (10) by means of a connection (24),
- at least one insulating body (18), which electrically insulates the post (14) and the terminal clamp (10) from each other, **characterized in that** means (18, 38, 40, 42) for rotationally fixing the post (14) with respect to the terminal clamp (10) are provided.

2. Device according to Claim 1, **characterized in that** a receptacle (20) with a receiving contour (42), which receives forces in the radial and/or axial direction with respect to the longitudinal axis of the post (14), is provided in the terminal clamp (10) as the rotationally fixing means.

3. Device according to Claim 2, **characterized in that** a securing contour (40), which interacts with the receiving contour (42), is provided on the post (14) as the rotationally fixing means.

4. Device according to Claim 3, **characterized in that** the securing contour (40) is of a star-shaped form.

5. Device according to either of Claims 3 and 4, **characterized in that** the insulating body (18) is arranged at least between the receiving contour (42) and the securing contour (40).

6. Device according to one of the preceding claims, **characterized in that** the insulating body (18) consists of a flexible material, preferably plastic or an elastomer.

7. Device according to one of the preceding claims, **characterized in that** the insulating body (18) is formed by an encapsulation.

8. Device according to one of the preceding Claims 1 to 6, **characterized in that** the insulating body (18) is formed by a coating (18") of the post (14).

9. Device according to one of the preceding claims, **characterized in that** the post (14) has a collar (38) running at least part of the way around it.

10. Device according to Claim 9, **characterized in that** the outside diameter of the collar (38) is smaller than the outside diameter of the insulating body (18).

11. Device according to either of the preceding Claims 9 and 10, **characterized in that** the collar (38) serves for receiving the measuring element (16).

12. Device according to one of the preceding claims, **characterized in that** the terminal clamp (10) and the measuring element (16) are mechanically and electrically conductively connected to each other by means of a compressive joint (34).

## Revendications

1. Dispositif comprenant :
- au moins une borne polaire (10) pour le raccordement à un pôle de batterie,
- au moins une unité électronique (22) ou un élément de mesure (16), connectés à la borne polaire (10),
- au moins un boulon (14) pour le raccordement d'un câble de batterie (12), le boulon (14) étant fixé mécaniquement par le biais d'une connexion (24) à la borne polaire (10),
- au moins un corps isolant (18), qui isole le boulon (14) et la borne polaire (10) électriquement l'un de l'autre, **caractérisé en ce que** des moyens (18, 38, 40, 42) sont prévus pour fixer en rotation le boulon (14) par rapport à la borne polaire (10).

2. Dispositif selon la revendication 1, **caractérisé en ce que** l'on prévoit comme moyens de fixation en rotation dans la borne polaire (10) un logement (20) avec un contour de réception (42) qui reçoit des forces dans la direction radiale et/ou axiale par rapport à l'axe longitudinal du boulon (14).

3. Dispositif selon la revendication 2, **caractérisé en ce que** l'on prévoit comme moyens de fixation en rotation un contour de fixation (40) sur le boulon (14), qui coopère avec le contour de réception (42).

4. Dispositif selon la revendication 3, **caractérisé en ce que** le contour de fixation (40) est réalisé en forme d'étoile.

5. Dispositif selon l'une quelconque des revendications 3 ou 4, **caractérisé en ce que** le corps isolant (18) est disposé au moins entre le contour de réception (42) et le contour de fixation (40).

6. Dispositif selon l'une quelconque des revendications précédentes, **caractérisé en ce que** le corps isolant (18) se compose d'un matériau flexible, de préférence de plastique ou d'un élastomère.

7. Dispositif selon l'une quelconque des revendications précédentes, **caractérisé en ce que** le corps isolant (18) est formé par surmoulage.

8. Dispositif selon l'une quelconque des revendications précédentes 1 à 6, **caractérisé en ce que** le corps isolant (18) est formé par un revêtement (18") du boulon (14).

9. Dispositif selon l'une quelconque des revendications précédentes, **caractérisé en ce que** le boulon (14) présente un rebord au moins en partie périphérique (38).

10. Dispositif selon la revendication 9, **caractérisé en ce que** le diamètre extérieur du rebord (38) est plus petit que le diamètre extérieur du corps isolant (18).

11. Dispositif selon l'une quelconque des revendications précédentes 9 ou 10, **caractérisé en ce que** le rebord (38) sert à recevoir l'élément de mesure (16).

12. Dispositif selon l'une quelconque des revendications précédentes, **caractérisé en ce que** la borne polaire (10) et l'élément de mesure (16) sont connectés l'un à l'autre mécaniquement et de manière électriquement conductrice au moyen d'un assemblage par pressage (34).
